# EUROPEAN PATENT APPLICATION

(11) **EP 1 437 826 A1**
(43) Date of publication of application: **14.07.2004**
(21) Application number: 03257891.6
(22) Date of filing: 16.12.2003
(51) Int. Cl.: H03F 1/32

(54) **Linearisation of amplified feedback distortion**

(30) Priority: 30.12.2002 US 330546
(71) Applicant: Nokia Corporation, 02150 Espoo (FI)
(72) Inventor: Phillips, Richard, Abbotts Ann, Hants SP11 7DR (GB)
(74) Representative: Williams, David John

(57) **Abstract**

There is disclosed a feedback circuit for providing a linearised signal indicating the distortion in an amplified signal, the feedback circuit having a plurality of selectable intermediate frequency paths corresponding to a plurality of distortion bandwidths.

## Description

### Field of the Invention

The present invention relates to the provision of a linearised signal in a feedback path from an amplified signal. The invention is particularly, but not exclusively, concerned with the minimisation of distortion in signals transmitted through power amplifiers, and particularly but not exclusively to power amplifiers implemented in a base transceiver station of a mobile communication system.

### Background to the Invention

Base transceiver stations (BTSs) of mobile communications systems are required to transmit signals across an air interface to mobile equipment, and as such are equipped with power amplifiers for amplification of a signal prior to transmission. Because of the distortion associated with the transmission of signals through power amplifiers, a feedback path is conventionally used to determine the distortion in the amplified signal, and then 'pre-distort' the signal at the input of the power amplifier to thereby cancel distortion from the signal at the output of the power amplifier.

For a base transceiver station operating in a multi-carrier/frequency mode, later on referred to as multi-x, the transmit path necessarily has a wide dynamic range, and consequently a wide dynamic range of signals is provided in the feedback path. The feedback path is used to down-convert the amplified signal in order to recover a measure of the distortion in the amplified signal, and apply this measure to pre-distortion algorithms. Such a multi-x base station may be provided in a 2.5G GSM/EDGE mobile communication system.

Effective down-conversion requires a very linear frequency conversion stage, which adds no additional distortion products to those generated in the primary transmit path (i.e. the power amplifier). Since the distortion products may be as low as -80dBc, then the sampling analogue-to-digital converter (ADC) used in the feedback path to generate digital signals from the down-converted signal is required to have a better linearity than this.. Since the distortion products are spread over a bandwidth which can be 3, 5 or 7 times greater than the multi-carrier transmit signal, the distortion bandwidth is very wide, requiring a very fast sampling frequency to ensure that all information is advantageously contained within one Nyquist zone.

The wide bandwidth requirements of such distortion products cannot be reliably processed in conventional feedback techniques.

It is an object of the present invention to provide an improved method to sample a feedback signal in a more linear manner, which preferably addresses one or more of the above-stated problems.

### Summary of the Invention

According to a first aspect of the present invention there is provided a feedback circuit for providing a linearised signal indicating the distortion in an amplified signal, the feedback circuit having a plurality of selectable intermediate frequency paths corresponding to a plurality of distortion bandwidths.

Each intermediate frequency path may include an amplifier having a center frequency associated with the intermediate frequency. Each amplifier may be associated with a band pass filter at an input thereof. Each amplifier may be associated with a band pass filter at an output thereof. The feedback circuit may further include a down converter.

The down converter may include a mixer for down converting the amplified signal. The mixer in the feedback path may selectively receive one of a corresponding plurality of reference signals used to convert the feedback signal into one of the different intermediate frequency paths.

The intermediate frequency paths may be selected to form an input to an analogue-to-digital converter. The plurality of intermediate frequency paths may be selected in an order determined by the bandwidth size of the corresponding distortion. The plurality of intermediate paths may be selected in order of decreasing bandwidth size. For each selected path a distortion measurement may be determined and used to pre-distort the signal input to the power amplifier. For each selected path a plurality of iterations of said measurement and pre-distortion may be performed.

A power amplifier may include such a feedback circuit. A base transceiver station of a mobile communication system may include such a feedback circuit.

According to a further aspect of the present invention there is provided a feedback circuit for providing a linearised signal indicating the distortion in an amplified signal, the feedback circuit having a plurality of selectable intermediate frequency paths corresponding to a plurality of distortion bandwidths, wherein the intermediate frequency paths are selected to form an input to an analogue-to-digital converter, the plurality of intermediate frequency paths being selected in an order determined by the bandwidth size of the corresponding distortion, and wherein for each selected path a distortion measurement is determined and used to pre-distort the signal input to the power amplifier.

In a still further aspect the present invention provides a method of providing a linearised signal indicating the distortion in an amplified signal, in which the amplified signal is selectively fed back through one of a plurality of selectable intermediate frequency paths, each path corresponding to one of a plurality of distortion bandwidths.

The method may further comprise down-converting the amplified signal, by selectively receiving one of a corresponding plurality of reference signals used to convert the feedback signal into one of the different intermediate frequency paths. The intermediate frequency paths may form an input to an analogue-to-digital converter. The plurality of intermediate frequency paths may be selected in an order determined by the bandwidth size of the corresponding distortion. The plurality of intermediate paths may be selected in order of decreasing bandwidth size.

The method may further comprise, for each selected path, determining a distortion measurement; and using said measurement to pre-distort the signal input to the power amplifier.

For each selected path a plurality of iterations of said measurement and pre-distortion may be performed.

According to a further aspect of the present invention there is provided a method for providing a linearised signal indicating the distortion in an amplified signal, comprising providing a plurality of selectable intermediate frequency paths corresponding to a plurality of distortion bandwidths, wherein the intermediate frequency paths are selected to form an input to an analogue-to-digital converter, the plurality of intermediate frequency paths being selected in an order determined by the bandwidth size of the corresponding distortion, and wherein for each selected path a distortion measurement is determined and used to pre-distort the signal input to the power amplifier.

Thus the present invention provides a multi-carrier down-converter receiver for a pre-distortion transmit path using switchable IF selection. The invention makes more efficient use of the linearity of the analogue-to-digital converter used in the down-conversion path than in conventional down-conversion stages. This is achieved by using selectively lower Nyquist zones as different iterations of the feedback algorithm are implemented to thereby increase the effective linearity, as only lower orders of distortion product are required.

### Brief Description of the Drawings

The invention will now be described by way of example with reference to the accompanying drawings in which:
Figure 1 illustrates a conventional down-conversion stage of a GSM/EDGE base transceiver station transmitter including a transmit pre-distortion feedback path;
Figure 2 illustrates performance characteristics of the A/D converter of Figure 1;
Figure 3 illustrates a down-conversion stage of a GSM/EDGE base transceiver station transmitter including a transmit pre-distortion feedback path in accordance with an embodiment of the invention;
Figure 4 illustrates the spectrum at the output of a power amplifier of Figure 2; and
Figure 5 illustrates an implementation of a base transceiver station implementing an embodiment of the present invention.

### Description of the Preferred Embodiments

The present invention is described by way of example with reference to an implementation in a 2.5G GSM/EDGE radio BTS transmitter. 2.5G refers to the generation of mobile telecommunications equipment which is considered to be halfway between second generation and fully fledged third generation. A GSM/EDGE system is such a 2.5G system. The skilled person will appreciate from the following description, however, that the principles of the present invention may be more broadly applicable.

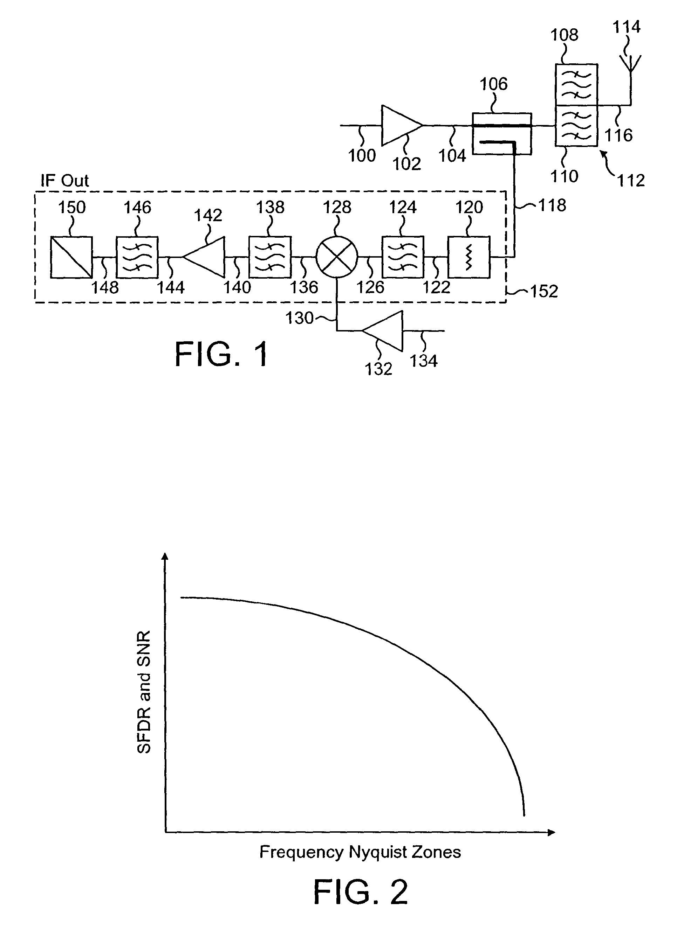

Referring to Figure 1, there is illustrated a feedback path of an adaptive pre-distortion system as known in the prior art, particularly for use in 2.5G GSM/EDGE BTS transmitters. The feedback path is taken from the coupled output of a power amplifier in the base transceiver station (BTS) transmitter.

Referring to Figure 1 reference numeral 102 identifies a power amplifier of the BTS transmit path. The power amplifier 102 receives a signal to be transmitted on line 100, and outputs an amplified version of such signal on line 104. The amplified signal on line 104 forms an input to an antenna duplexer 112, including first and second band-pass filters 108 and 110. The antenna duplexer 112 provides an output on line 116, which drives an antenna 114.

A directional coupler 106 is located in the path of the signal line 104 at the output of the power amplifier 102, and generates an output on line 118. The output on line 118 generated by the directional coupler 106 represents properties of the signal at the output of the power amplifier 102.

The signal on line 118 forms an input to an attenuator 120, and provides an output on line 122. The output on line 122 forms an input to a RF (radio frequency) band pass filter 124. The output of the band pass filter on line 126 forms a first input to a mixer 128. A local oscillator (not shown) provides a signal on line 134 to an amplifier 132. The amplifier 132 provides an amplified version of the local oscillator on signal line 130, which forms a second input to the mixer 128.

The mixer 128 has an output on line 136, which forms an input to a band pass filter 138. The output of the band pass filter 138 on line 140 forms an input to an amplifier 142, the output of which on line 144 forms an input to a band pass filter 146. The output of the band pass filter on line 148 forms an input to an analogue-to-digital converter 150.

The operation of the circuitry of Figure 1, and the disadvantages of such, are now described in order to place the invention in context.

In a multi-carrier base station including the circuitry of Figure 1, the bandwidth occupied by the carriers may be represented by *x* MHz. The feedback path, represented by dashed box 152 in Figure 1, down-converts a coupled portion of the carriers at the output of the power-amplifier 102 to an intermediate frequency (IF) on line 148, which is sampled by the ADC 150.

A digital representation of the IF signal on line 148, generated by the ADC 150, is then used within known distortion algorithms to determine how much distortion is present in the feedback signal. The determined distortion is then used to 'pre-distort' the transmitted signal, to compensate for the distortion. Specifically, the distortion produced from the 3^{rd}, 5^{th} and possibly 7^{th} order distortion effects is determined. The overall bandwidth of these products occupies 3*x*, 5*x* or 7*x*MHz respectively. From now on the 5^{th} order distortion bandwidth is used as an example for the feedback bandwidth requirement.

Since all this distortion information must be contained within one Nyquist zone, then the clock speed of the ADC 150 must be greater than twice this bandwidth, typically 20% greater to ensure that aliasing does not occur. This places a limit on the centre frequency of the IF band to be sampled of 11*x* MHz (i.e. 2 times 5*x* MHz + 0.2*5*x* MHz). This can easily result in using a high order Nyquist zone, where the precious dynamic range of the ADC 150 is compromised.

Furthermore, if a wide IF is sampled in the first order Nyquist zone of an ADC, harmonics of the lowest frequencies could fall within the IF bandwidth, therefore having the effect of creating further unwanted distortion. This effect is lost if the lowest frequency within the IF sampling bandwidth is less than half the highest frequency. Harmonics then fall outside of the wanted bandwidth and may be filtered out.

Current ADC technologies generally give best spurious free dynamic range (SFDR) and signal to noise ratio (SNR) performance in the first order Nyquist zone. The performance of higher order Nyquist zones degrade with increasing frequency. Consequently the need to use higher order Nyquist zones for wide IF applications is in contradiction with performance of commercially available parts.

Figure 2 shows typical shapes for the SFDR and the SNR performance with increasing Nyquist zones, and clearly illustrates the degradation in performance as the order of the zones increases.

If a wider multi-carrier transmit path is required for future applications, e.g. 1.5 *x*MHz, then the required 3^{rd} and 5^{th} order bandwidths increase accordingly to 4.5*x* and 7.5*x* MHz respectively. This further pushes the required clock speed of the ADC further up in order to ensure that the available IF bandwidth is contained within only one Nyquist zone.

Figure 1 shows a conventional down-conversion stage. The centre frequency of the IF is fixed such that the local oscillator signal frequency on line 134 is set to be the sum or the difference of the RF and IF frequencies. The centre frequency of the IF, in the band pass filter 146, is chosen to provide enough bandwidth to fully capture the bandwidth of the 3^{rd} and 5^{th} order products. Greater bandwidths may be required to give greater overall linearity, and this would have the effect of pushing the centre frequency of the IF up in frequency.

The present invention therefore proposes extending the overall dynamic range of a down-conversion block used in the feedback path by using different IFs as iterations are completed for the pre-distortion algorithm. Lower IFs are used with increasingly narrower bandwidths, thus enabling lower Nyquist zones to be used where a greater SFDR for the ADC is available.

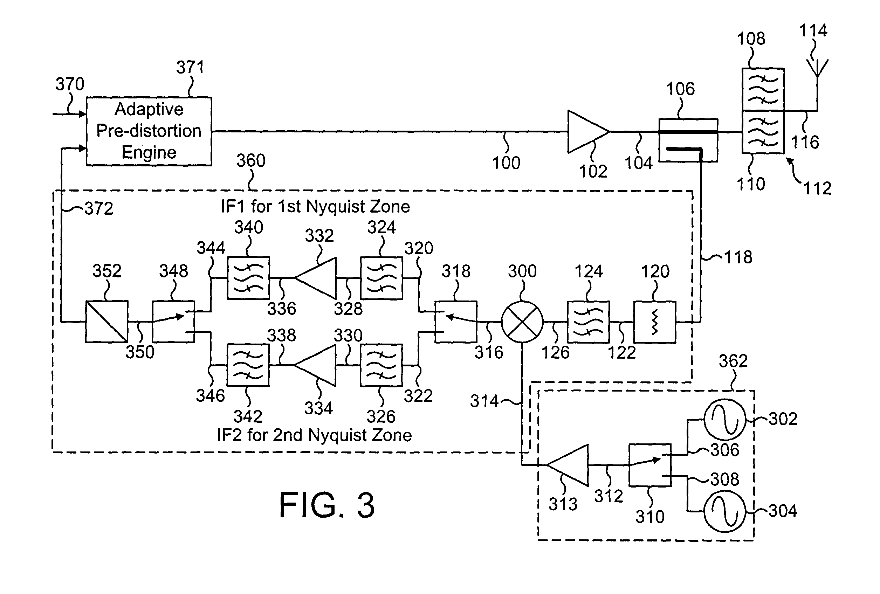

Referring to Figure 3, there is illustrated the implementation of a pre-distortion feedback path in accordance with an embodiment of the present invention. The same reference numerals are used to identify elements that correspond to elements of Figure 1.

In accordance with the present invention, and as described further hereinbelow, the down-converter features two independent IF paths tuned to different centre frequencies to match differing Nyquist zones.

As with Figure 1, the power amplifier 102 of the BTS transmit path receives a signal to be transmitted on line 102, and outputs an amplified version of such signal on line 104. The amplified signal on line 104 is input to the antenna duplexer 112. The antenna duplexer 112 drives the antenna 114 via line 112. The directional coupler 106 generates an output on line 118 representing properties of the signal at the output of the power amplifier 102.

The signal on line 118, representing the RF transmitted signal including the distortion bandwidth, is input to the attenuator 120 , which provides the signal on line 122 to the band pass filter 124. The output of the band-pass filter on line 126 forms the first input to a mixer 300.

A second input to the mixer 300, on a line 314, is provided by a reference circuit generally designated by reference numeral 362. The reference circuit 362 includes a first local oscillator 302 and a second local oscillator 304, which provide respective local oscillator signals on lines 306 and 308 to respective first and second inputs of a switch 310. The single output of the switch 310 on line 312 forms an input to an amplifier 313, which forms at its output the second input to the mixer on line 314. The switch 310 is controlled, as described further herein below, to connect one of the two inputs on lines 306 and 308 to its output on line 312.

The mixer 300 thus operates to down-convert the signal on line 118 for further processing. The attenuator 120 and the band pass filter merely pre-process the signal on line 118 prior to application to the mixer 300. The reference circuit 362 provides reference frequency signals for the mixer for down-conversion. As will be described in further detail herein below, the reference circuit 362 generates one of two reference signals for the mixer. A first reference frequency signal corresponds to local oscillator 302, and a second reference frequency signal corresponds to local oscillator 304.

The mixer 300 provides an output on line 316, which forms a single input to a switch 318. The switch 318 has two outputs on lines 320 and 322, the switch being controlled to provide the signal on line 316 on one of the outputs 320 and 322, as will be described further herein below.

The signal on line 320 forms an input to a band pass filter 324. The output of the band pass filter 324 on line 328 forms an input to an amplifier 332, the output of which on line 336 forms an input to a band pass filter 340. The output of the band pass filter 340 on line 344 forms a first input to a switch 348. The signal on line 322 forms an input to a band pass filter 326. The output of the band pass filter 326 on line 330 forms an input to an amplifier 334, the output of which on line 338 forms an input to a band pass filter 342. The output of the band pass filter 342 on line 346 forms a second input to the switch 348.

The amplifiers 332 and 334, and the band pass filters at their respective inputs and outputs, form intermediate frequency (IF) paths tuned to different centre frequencies. The different centre frequencies match respective different Nyquist zones.

The selection of the centre frequencies for the IF paths is discussed further herein below. Each of the IF paths is associated with one of the reference frequencies of the local oscillators 302 and 304, as discussed further herein below.

The switch 348 is controlled, as described further herein below, to connect one of the inputs on signal lines 344 and 346 to its output on signal line 350. The output on signal line 350 forms an input to an analogue-to-digital converter (ADC) 352.

Referring further to Figure 3, the ADC 352 generates an output on line 372, which forms an input to an adaptive pre-distortion engine 371. The algorithm block uses the distortion information on line 372 from the ADC 352 to adapt the signal for transmission on line 370, and then applies the pre-distorted signal to the input of the power amplifier 102. The algorithm block is a conventional algorithm block as may be used in conjunction with the circuitry of Figure 1. The invention is not concerned with the operation or function of the adaptive pre-distortion engine block 371, nor is it concerned with the implementation of the ADC 352. Rather the invention is concerned with the generations of the signal on line 350 forming an input to the ADC 352.

The adaptive algorithms used in the algorithm block 370 to 'pre-distort' the transmission signal at the input of the amplifier 102 follow the sequence of ***Pre-Distort > Measure > Adapt > Pre-Distort > Measure > Adapt > etc.*** That is they iterate through a sequence of pre-distorting the transmission signal, measuring the feedback signal, and adapting the pre-distortion in dependence upon the feedback signal. A number of iterations is preferably made, each in turn reducing the overall non-linearities of the output of the power amplifier 102. After a number of initial cycles of the pre-distortion routine have had their effect, the non-linearities at the power-amplifier are successively reduced.

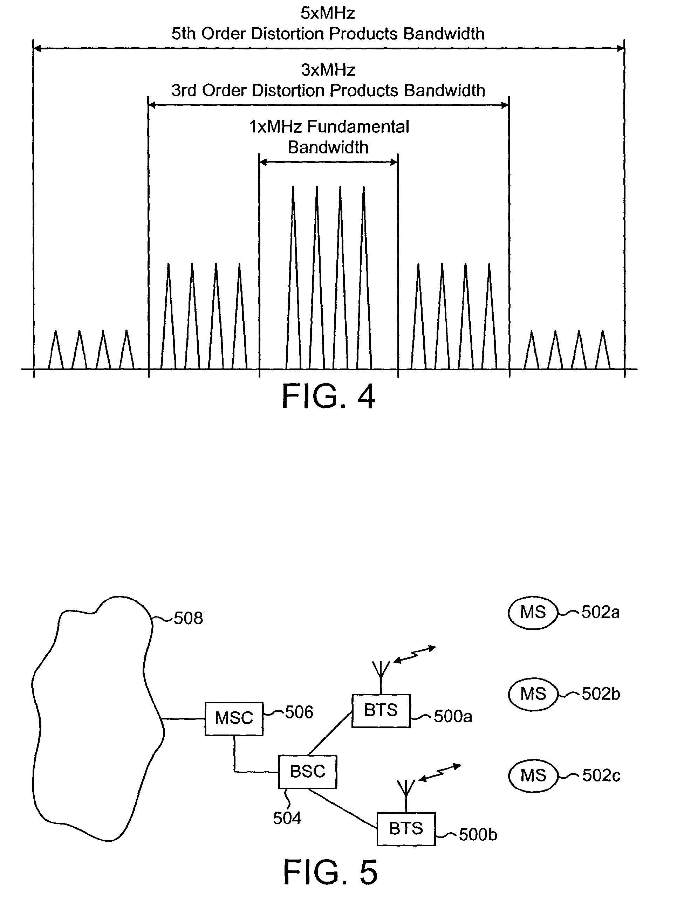

For the description of this embodiment, as discussed hereinabove with reference to Figure 3, the required bandwidth of 3^{rd} order products and 5^{th} order products is used. Wider bandwidths can be considered and are valid, and can be inferred from the following discussion. The spectrum at the output of the power amplifier 102 is shown in Figure 4, for the fundamental bandwidth, the 3^{rd} order distortion products bandwidth, and the 5^{th} order distortion products bandwidth.

The 5^{th} order distortion products are preferably reduced first, and then followed by reduction of the 3^{rd} order distortion products.

Thus, for initial iterations of the algorithm, to deal with the fifth order distortions, the output from local oscillator 304 on line 308 is output on line 312 by the switch 310. The switches 348 and 318 are set such that signals are transmitted on signal lines 322, 330, 338, 346 to the ADC 352. Thus the IF path associated with amplifier 334 is used to down-convert the signal containing the 5th order distortions, with the reference signal from the local oscillator 304 providing the down-conversion.

As the 5^{th} order products drop below the noise floor of the ADC 352, the full 5^{th} order bandwidth is no longer required, and the IF bandwidth can be reduced. In the act of reducing this bandwidth, the centre frequency of the IF can also be reduced, as harmonic products within the sampling Nyquist zone no longer fall with the IF bandwidth.

As the centre frequency of the IF can be reduced, the operating point of the ADC 352 can move to the left (referring to Figure 2). This is achieved by having two selectable IF stages.

Thus, when the narrower IF bandwidth is used, to deal with the third order distortions, the output from local oscillator 302 on line 306 is output on line 312 by the switch 310. The switches 348 and 318 are set such that signals are transmitted on signal lines 320,328,336,344 to the ADC 352. Thus the IF path associated with amplifier 332 is used to reduce the 3rd order distortions, with the reference signal from the local oscillator 302 providing the down-conversion.

The invention enables either a lower specified ADC to be used, or a greater overall linearity to be achieved within the feedback path, thus giving a more linear achievable transmission signal through the power amplifier.

The circuitry of the conventional down-conversion stage in accordance with the invention requires components which are cheap and easy to implement.

The local oscillators may be implemented with a sub-band switched voltage controlled oscillator, therefore negating the overall need for 2 synthesizers and a switch, as shown in the reference circuit 362 in Figure 3. This is possible because both reference frequencies are not required at the same time.

It will be appreciated by one skilled in the art that whilst the embodiment of the invention has been described by way of reference to an example where it is required to process two orders of distortion, the techniques disclosed apply equally to analyzing higher orders of distortion. Multiple reference frequencies may be generated in the reference circuit 362, and corresponding multiple parallel paths nay be provided in the feedback circuit 360.

In addition, if a wider multi-carrier transmit path is required in the future, e.g. 1.5 *x* MHz, then the required 3^{rd} and 5^{th} order bandwidth may increase accordingly to 4.5 *x* and 7.5 *x* MHz respectively, pushing the clock speed up further to ensure that the available IF bandwidth was contained within only one Nyquist zone.

For completeness, an example implementation of a base transceiver station implementing feedback circuitry in accordance with the present invention is described with reference to Figure 5.

Referring to Figure 5, as is known in the art there is illustrated two BTSs 500a and 500b providing network connections to a plurality of mobile stations (MS) 502a,502b,502c. The BTSs 500a and 500b are associated with a base station controller (BSC) 504, which in turn is associated with a mobile switching center 506. The mobile switching center is further connected to a mobile communications network 508, such as a GSM/EDGE network. Implementations of such mobile communications networks utilizing BTSs are well-known to one skilled in the art.

Although the present invention has been described herein by way of reference to a particular embodiment, one skilled in the art will appreciate that the invention is not limited to such an embodiment. More generally, the invention may be considered to apply to power amplification, and is not limited specifically to mobile communication environments.

The scope of protection afforded by the present invention is defined by the appended claims.

## Claims

1. A feedback circuit for providing a linearised signal indicating the distortion in an amplified signal, the feedback circuit having a plurality of selectable intermediate frequency paths corresponding to a plurality of distortion bandwidths.

2. A feedback circuit according to claim 1 wherein each intermediate frequency path includes an amplifier having a center frequency associated with the intermediate frequency.

3. A feedback circuit according to claim 2 wherein each amplifier is associated with a band pass filter at an input thereof.

4. A feedback circuit according to claim 2 wherein each amplifier is associated with a band pass filter at an output thereof.

5. A feedback circuit according to claim 1 further including a down converter.

6. A feedback circuit according to claim 5 wherein the down converter includes a mixer for down converting the amplified signal.

7. A feedback circuit according to claim 6 wherein the mixer in the feedback path selectively receives one of a corresponding plurality of reference signals used to convert the feedback signal into one of the different intermediate frequency paths.

8. A feedback circuit according to claim 1 wherein the intermediate frequency paths are selected to form an input to an analogue-to-digital converter.

9. A feedback circuit according to claim 1 wherein the plurality of intermediate frequency paths are selected in an order determined by the bandwidth size of the corresponding distortion.

10. A feedback circuit according to claim 9wherein the plurality of intermediate paths are selected in order of decreasing bandwidth size.

11. A feedback circuit according to claim 1, wherein for each selected path a distortion measurement is determined and used to pre-distort the signal input to the power amplifier.

12. A feedback circuit according to claim 11, wherein for each selected path a plurality of iterations of said measurement and pre-distortion are performed.

13. A power amplifier including a feedback circuit according to claim 1.

14. A base transceiver station of a mobile communication system including a feedback circuit according to claim 1.

15. A feedback circuit for providing a linearised signal indicating the distortion in an amplified signal, the feedback circuit having a plurality of selectable intermediate frequency paths corresponding to a plurality of distortion bandwidths, wherein the intermediate frequency paths are selected to form an input to an analogue-to-digital converter, the plurality of intermediate frequency paths being selected in an order determined by the bandwidth size of the corresponding distortion, and wherein for each selected path a distortion measurement is determined and used to pre-distort the signal input to the power amplifier.

16. A method of providing a linearised signal indicating the distortion in an amplified signal, in which the amplified signal is selectively fed back through one of a plurality of selectable intermediate frequency paths, each path corresponding to one of a plurality of distortion bandwidths.

17. A method according to claim 16 further comprising down-converting the amplified signal, by selectively receiving one of a corresponding plurality of reference signals used to convert the feedback signal into one of the different intermediate frequency paths.

18. A method according to claim 16 wherein the intermediate frequency paths form an input to an analogue-to-digital converter.

19. A method according to claim 16 wherein the plurality of intermediate frequency paths are selected in an order determined by the bandwidth size of the corresponding distortion.

20. A method according to claim 19 wherein the plurality of intermediate paths are selected in order of decreasing bandwidth size.

21. A method according to claim 16, further comprising, for each selected path, determining a distortion measurement; and using said measurement to pre-distort the signal input to the power amplifier.

22. A method according to claim 21, wherein for each selected path a plurality of iterations of said measurement and pre-distortion are performed.

23. A method for providing a linearised signal indicating the distortion in an amplified signal, comprising providing a plurality of selectable intermediate frequency paths corresponding to a plurality of distortion bandwidths, wherein the intermediate frequency paths are selected to form an input to an analogue-to-digital converter, the plurality of intermediate frequency paths being selected in an order determined by the bandwidth size of the corresponding distortion, and wherein for each selected path a distortion measurement is determined and used to pre-distort the signal input to the power amplifier.
